# EUROPÄISCHE PATENTSCHRIFT

(11) **EP 2 649 609 B1**
(45) Veröffentlichungstag und Bekanntmachung des Hinweises auf die Patenterteilung: **26.09.2018**
(21) Anmeldenummer: 11802006.4
(22) Anmeldetag: 02.12.2011
(51) Int. Cl.: G09F 23/00, G09F 13/22, G09F 9/35

(54) **ANZEIGE**
DISPLAY
DISPOSITIF D'AFFICHAGE

(30) Priorität: 08.12.2010 DE 102010061123; 08.12.2010 DE 202010013087 U; 06.06.2011 DE 102011050878
(43) Veröffentlichungstag der Anmeldung: 16.10.2013
(60) Teilanmeldung: 17198018.8
(73) Patentinhaber: Schott AG, 55122 Mainz (DE)
(72) Erfinder: ZENKER, Thomas, 55268 Nieder-Olm (DE)
(74) Vertreter: Herrmann, Jochen
(86) Internationale Anmeldenummer: PCT/EP2011/071627
(87) Internationale Veröffentlichungsnummer: WO 2012/076412

(56) Entgegenhaltungen:
- EP-A1- 2 068 192
- DE-A1-102004 034 761
- DE-A1-102009 013 127

## Beschreibung

Die Erfindung betrifft eine Anzeige mit einem Substrat, zumindest teilweise bestehend aus einem teiltransparentem Werkstoff, mit inhomogenem spektralen Transmissionsverlauf, wobei das Substrat eine Anzeigeseite und eine Rückseite aufweist, wobei im Bereich der Rückseite wenigstens ein Leuchtelement angeordnet ist, welches von einer Regeleinheit gesteuert wird.

Aus dem Stand der Technik sind unterschiedliche Möglichkeiten zur Hinterleuchtung von transparenten oder teiltransparenten Substraten bekannt. Als Substrate kommen dabei beispielsweise glasige Werkstoffe, bestehend aus einem Glas- oder Glaskeramikmaterial, zum Einsatz.

So sind insbesondere Glaskeramikkochfelder bekannt, die aus einer eingefärbten Glaskeramik bestehen. Die Einfärbung ist erforderlich, um den Einblick auf die rückseitig angeordneten technischen Einbauten wie Heizelemente und Leiter zu verhindern. Um nun auf der Vorderseite der Glaskeramik Leuchteffekte zu erzielen, werden rückseitig Leuchtelemente eingesetzt, die durch die Glaskeramik hindurch scheinen. Aufgrund des inhomogenen Transmissionsverlaufs des Substratmaterials entsteht beim Lichtdurchtritt von Mischfarben, bzw. nicht-monochromatischer Leuchtelemente durch die Glaskeramik eine Farbverschiebung, so dass der Farbort des vom Leuchtelement ausgesandten Lichtes sich von der Anzeige auf der Anzeigenseite unterscheidet. Bei Substratwerkstoffen mit überwiegend roter Transmission, wie der bisher handelsüblichen Glaskeramikkochflächen, können vorzugsweise rote Anzeigen verwirklicht werden. Die begrenzte Auswahl einfarbiger LED-Anzeigen und der eingeschränkte Transmissionsverlauf bisheriger Glaskeramiken schränkt das zur Verfügung stehende Farbspektrum für die Benutzerinformation sehr stark ein. Standardmäßig sind diese Anzeigen nur auf rot oder teils auch auf orange, gelb und grün beschränkt, was sich auch aufgrund der Einfärbung der Glaskeramikkochfläche ergibt.

In der DE 10 2008 050 263 wird der Transmissionsverlauf für eine Glaskeramikkochfläche beschrieben, die insbesondere auch eine Durchlässigkeit für blaues Licht bei ca. 450 nm zulässt und damit eine erweiterte farbliche Anzeigefähigkeit erlaubt.

In der DE 10 2009 013 127 A1 sind auf Basis dieser Glaskeramik unterschiedliche Anzeigemöglichkeiten aufgezeigt. Durch die Erweiterung des Transmissionsspektrums auch auf den blauen Wellenlängenbereich ist zwar die Farbgebung der Anzeigen erweitert worden. Aufgrund der geringen Anzahl einfarbiger, nahezu monochromatischer LED-Anzeigen ist jedoch auch bei dieser Glaskeramik-Kochfläche die Anzahl der für den Benutzer sichtbaren Farben stark eingeschränkt. Eine weiße LED würde beispielsweise aufgrund des Transmissionsverlaufes der Kochfläche für den Benutzer mit einem deutlichen Gelbstich wahrgenommen. Auch der Farbort einer Mischfarbe aus der Kombination aus mindestens zwei farbigen LEDs wird sich auf der Anzeigenseite verschieben. Der Farbort der Leuchtelemente ist nur dann nicht verschoben, wenn es sich um einzelne, nahezu monochromatische Leuchtelemente wie einfarbige LEDs handelt.

Werden Mischfarben aus mindestens zweier solcher beispielsweise einfarbiger LEDs oder spektral breitbandige Leuchtelemente, wie beispielsweise weiße LEDs oder Leuchtstoffröhren eingesetzt, so wird durch einen inhomogenen Transmissionsverlauf eines Substratwerkstoffes eine Verschiebung des Leuchtelement-Farbortes auf der Anzeigenseite hervorgerufen.

EP 2 068 192 A1 und US 2007/0285378 A1 offenbaren Lichtquellen für ein LCD-Display.

DE 10 2004 034 761 A1 beschreibt ein Kochsystem mit einer Anzeigevorrichtung und einem Kochfeld. Die Anzeigevorrichtung ist unter dem Kochfeld angeordnet. Sie weist eine Vielzahl von matrixförmig angeordneten Leuchtdioden auf.

Bekannt sind ferner farbige Anzeigen, wie Farbfernseh-Elektronenstrahlröhren oder eine Vielzahl von technischen Variationen von Farb-LCD Displays, die aufgrund von mindestens 3 Grundfarben den gesamten Farbraum im Farbpolygon zwischen den verwendeten Grundfarben, bei Rot-Grün-Blau (RGB) im RGB-Farbdreieck, des CIE-Farbraums (CIE-Commission internationale de l'eclaireage, Normvalenzystem, sRGB siehe IEC 61966-2-1) abbilden können, insbesondere auch den Weißpunkt. Im Allgemeinen werden als Grundfarben RGB eingesetzt. Es gibt auch Anwendungen, bei denen mehr als 3 Grundfarben zum Einsatz kommen, zum Beispiel zusätzlich Cyan, Gelb und Magenta. Sind farbige Leuchtdioden (LED) die Lichtquellen, so werden die mit LEDs verfügbaren Spektralfarben RGB als Grundfarben eingesetzt, beispielsweise mit den Wellenlängen 470 nm, 520 nm und 630 nm.

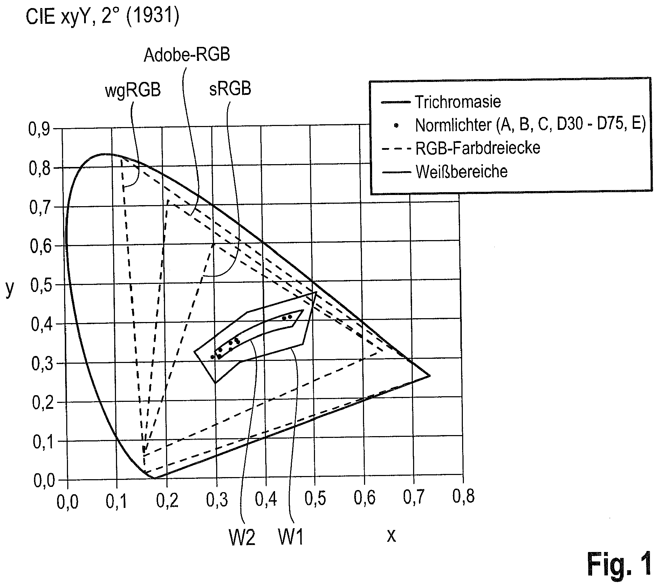

Bei Substraten, mit einem relativen Transmissionsunterschiede schon von 50% zwischen 470 nm und 630 nm, zeigen sich schon merkliche und störende Farbortverschiebungen von marktüblichen weißen Anzeigen oder Farbanzeigen. Bei Substraten, bei denen zwischen 470 nm und 630 nm die relativen Transmissionsunterschiede etwa 80% oder mehr betragen, zeigt sich, dass mit marküblichen farbigen Anzeigen der gesamte Farbraum, insbesondere der Weißpunkt, nicht mehr dargestellt werden kann. Dies gilt insbesondere für handelsüblichen Farbdisplays, bei denen die Grundfarben mittels Farbfilter oder Farbphosphoren oder anderen Farblumineszenzmaterialien erzeugt werden. Diese werden herkömmlich in einer Lochmaske vor einer weißen Hintergrundbeleuchtung oder Elektronenstrahlquelle oder einer blauen Lichtquelle oder einer UV Lichtquelle eingesetzt, um die drei RGB-Farben zu erzeugen. Dies ist derzeit bei allen kommerziellen Farbanzeigen, wie sie in PC-Displays, TV, PDA, CRT, Mobiltelefonen und anderen Anwendungen zum Einsatz kommen, der Fall. Solche auf Farbfilter basierte Anzeigen sind nicht geeignet, um bei Substraten mit derart spektral inhomogener Transmission für die unterschiedlichen Spektralfarben den gesamten Farbraum auf der Anzeigeebene darzustellen. Die Ursache hierbei sind zu breitbandige Filter oder Lumineszenzen, von 100 nm FWHM (Halbwertsbreite) oder mehr, so dass die Grundfarben des Farbdreiecks durch die inhomogene Filterwirkung des Substrats derart im CIE-Farbraum verschoben werden, dass der Weißpunkt auf der Anzeigenseite des Substrates nicht mehr darstellbar ist, insbesondere bei Anzeigen, deren ursprünglicher Farbraum sehr eingeschränkt ist, beispielsweise der sRGB Farbraum (IEC 61966-2-1 , vgl. Figur 1). Ebenso wenig können weiße Anzeigen, die handelsüblich auf weißem, breitbandigem Fluoreszenzlicht beruhen, wie Leuchtstoffröhren, weiße LEDs oder auch Glühleuchten, nicht unter einem solchen Substrat eingesetzt werden, um auf der Anzeigeebene einen weißen Farbeindruck zu erzeugen. Insbesondere wird der Weißpunkt zu einem Farbort in Richtung höherer spektraler Transmission des CIE-Polygons verschoben.

Bekannt sind aber auch Farbdisplays, die ohne Farbfilter aufgebaut sind. Deren Farbwiedergabe basiert auf einer sequentiellen Farbansteuerung. Diese Technik ist seit der Entwicklung von Farbfernsehern bekannt. In neueren Entwicklungen von Farb-LCD-Displays findet diese Technik mittlerweile auch Anwendung. Es lassen sich effizienter höhere Helligkeiten sowie größere Farbräume erzeugen. Technisch war dies bisher durch die erforderlichen schnellen Schaltzeiten der LCD-Einheiten limitiert. Die Farbmischungen werden hier direkt über die drei RGB-Farben einer RGB-Hinterleuchtung ohne den Umweg über breitbandige Farbfilter erzeugt. Dabei werden die RGB-Farben sequentiell angesteuert, so dass in schneller Abfolge (< 1/180 Sek) ein rotes, grünes und blaues Teilbild erzeugt wird, welches das Auge zeitlich nicht auflösen kann und so als Farbsegment wahrgenommen wird. Sowohl der Farbpunkt als auch die Helligkeit der einzelnen Bildpunkte können zum Beispiel durch eine unterschiedliche Helligkeitsansteuerung (Graustufen) der LCD-Bildpunkte während der einzelnen Farb-Teilbilder erzeugt werden (zum Beispiel US 7123228, US 2005116921, US 7486304, US 2008211973A, US 2007285378 A,
US 2002159002A, DE 19631700). Auch hier wird der beim Display eingestellte Weißpunkt durch die unterschiedliche Transmission der RGB-Grundfarben verschoben und somit die Farbdarstellung verfälscht.

Bei Anzeigen durch Trägermaterialien mit spektral inhomogener Transmission im Bereich zwischen 380 nm bis 780 nm, zum Beispiel farbigen Gläsern, lässt sich prinzipiell auch hier der gesamte Farbraum in einem gewählten CIE-Polygon darstellen, weiß eingeschlossen, sofern alle gewählten spektralen Grundfarben das Trägersubstrat zumindest teilweise durchdringen. Dies gilt auch für neuere schwarze Glaskeramiktypen, beispielsweise nach DE 10 2008 050 263 oder auch für solche, die durch Einfärbung mit Ti3+ mittels reduzierender Läuterung (beispielsweise ZnS-Läuterung) hergestellt werden.

Es ist Aufgabe der Erfindung, eine Anzeige der eingangs erwähnten Art zu schaffen, mit der sich bei Substraten mit inhomogenen Transmissionsverlauf ansprechende Lichteffekte innerhalb des sichtbaren Lichtspektrums erzeugen lassen.

Diese Aufgabe wird dadurch gelöst, dass das Leuchtelement mindestens zwei, vorzugsweise drei Grundfarben-Leuchten aufweist und dass die Grundfarbenhelligkeit von wenigstens einer der Grundfarben-Leuchten gegenüber der Einstellung ohne Substrat angepasst ist, so dass die Farbortverschiebung durch den inhomogenen Transmissionsverlauf kompensiert werden kann, insbesondere ein Farbpolygon im CIExyY-Farbraum aufgespannt wird, das weiße Farborteinstellungen ermöglicht. Die Farbortkompensation und Farborteinstellungen werden durch eine Regeleinheit eingestellt. Durch die Verwendung von getrennt ansteuerbaren Grundfarbenleuchten werden weiterhin Anwendungen möglich, die mit beliebigem, auch wechselndem Farbort, einfarbige Anzeigen ermöglichen, oder farbige Anzeigen, speziell auch von der Art, die eine sequentielle Ansteuerung der Grundfarben erfordern.

Mit einer Anpassung der Grundhelligkeiten der Grundfarben-Leuchten lässt der Farbort auf der Anzeigenseite des Substrats auf den ursprünglichen Farbort einer einfarbigen Anzeige in Abhängigkeit von der Transmission des Substratwerkstoffes kompensieren, insbesondere auf einen weißen Farbort. Bei farbigen Anzeigen (Displays) lässt sich entsprechend der Weißabgleich korrigieren.

Im Allgemeinen ist die erfindungsgemäße Technik für alle teiltransparenten Gläser, Glaskeramiken oder andere teiltransparente Substrate einsetzbar, die eine spektral inhomogene Transmission für die gewählten Grundfarben, insbesondere der RGB-Grundfarben, aufweisen. Dies kann ein kontinuierlicher Transmissionsbereich sein, mit spektral unterschiedlichen Transmissionswerten von kleiner als 100%, oder auch mit voneinander abgegrenzten RGB-Transmissionsfenstern solcher Transmissionswerte, welche die Transmission eines RGB-Farbtripels oder anderer Grundfarben eines Farbpolygons zulassen.

Um mit handelsüblichen Leuchtmitteln (beispielsweise LEDs) durch die Glaskeramik hindurch auf der von der Glaskeramikvorderseite gebildeten Anzeigenseite genügend helle Farbeindrücke im blauen bis roten Spektralbereich hervorzurufen, sind Glaskeramiken erforderlich, die eine mittlere Transmission von >0,2%, vorzugsweise von >0,4%, jeweils für jeden der Spektralbereich von 420-500 nm, 500-620 nm und 550-640 nm aufweisen. Andererseits darf auch die spektrale Transmission nicht zu hoch sein, um ohne zusätzliche Hilfsmittel, wie lichtdichte Unterseitenbeschichtungen, ein Einblick in den Innenaufbau der Kochfelder zu verwehren und eine ästhetisch bevorzugte, farbig gleichförmige, nicht transparente Kochfläche darzustellen. Diese maximale Transmission wird vorliegend mit <40%, vorzugsweise <25% bei 400 nm bis 700 nm, definiert und zusätzlich im Mittel von <4% zwischen 450-600 nm. Solche Substrate werden häufig auch als "schwarze Glaskeramiken" bezeichnet, die eine besonders gute optische Abdeckung bieten, um technische Einbauten uneinsehbar zu halten.

Gemäß einer bevorzugten Erfindungsausgestaltung kann es vorgesehen sein, dass das Substrat ein Transmissionsunterschied d_{T} im Wellenlängenbereich zwischen 470 nm und 630 nm von d_{T} > 80%, bevorzugt 95% > d_{T} > 80% aufweist. Bei solchen Substraten können mit den erfindungsgemäßen Anzeigen weiße und im gewählten Farbraum farbige Anzeigen verwirklicht werden, die so vorher nicht darstellbar waren.

Eine bevorzugte Erfindungsausgestaltung ist derart, dass die relativen Transmissionsunterschiede des Substrats bei einer Wellenlänge von 520 nm im Bereich zwischen 9% und 15% und bei einer Wellenlänge von 470 nm 7% und 13% relativ zu der Transmission bei einer Wellenlänge von 630 nm beträgt. Solche Substrate mit anteiliger, "blauer" Transmission sind optisch ansprechend und können mit den Anzeigen auf der Anzeigenseite insbesondere auch weiß ausleuchten.

Eine mögliche Anzeige ist derart, dass das Leuchtelement drei Grundfarben-Leuchten umfasst, von denen eine rotes, eine grünes und eine blaues Licht entsprechend einem RGB-Dreieck des CIE-Farbraums emittiert. Diese Grundfarben-Leuchten können als standardisierte Bauteile kostengünstig bezogen werden. Zudem sind diese Grundfarben-Leuchten, die beispielsweise als LEDs ausgeführt sind, ausreichend schmalbandig, so dass sich beispielsweise durch die vorbeschriebenen Substratmaterialien ein korrigierter RGB-Farbraum und insbesondere der Unbuntpunkt E (x=1/3, y=1/3, CIExyY 1931) darstellen lassen. Eine Ausgestaltung mit dreiLED-Grundfarben-Leuchten (4.1) ist derart, dass eine zwischen den dominanten Wellenlängen von 580 nm und 750 nm, eine zweite zwischen 480 nm und 590 nm und eine dritte zwischen 400 nm und 505 nm Licht emittiert. Vorzugsweise finden drei LED-Grundfarben-Leuchten Verwendung, die bei den dominanten Wellenlängen von 470 nm, 520 nm und 630 nm mit einer Abweichung der dominanten Wellenlänge von ±5 nm Licht emittieren.

Eine weiter bevorzugte Erfindungsausgestaltung ist derart, dass das Leuchtelement zwei Grundfarben-Leuchten umfasst, und dass die Verbindungslinie der Farborte dieser Grundfarben-Leuchten im CIExyY-Diagramm den Weißbereich W1, insbesondere den Weißbereich W2, schneidet oder tangiert, besonders bevorzugt die Planckfarbkurve schneidet.

Mit einer solchen Ausführung eines Leuchtelementes lassen sich besonders kleinbauende Anzeigen verwirklichen.

Dabei kann es insbesondere vorgesehen sein, dass die Peakwellenlänge einer der beiden Grundfarben-Leuchten im Bereich zwischen 420 nm und 510 nm, besonders bevorzugt im Bereich zwischen 468 nm und 483 nm, beträgt, und/oder dass die Peakwellenlänge einer der beiden Grundfarben-Leuchten im Bereich zwischen 550 nm und 670 nm, besonders bevorzugt im Bereich zwischen 570 nm und 585 beträgt.

Diese Grundfarben-Leuchten eignen sich insbesondere für die Durchleuchtung gängiger eingefärbter Glaskeramiken, wobei sich dabei auf der Anzeigeseite des Substrates dann weiße Leuchterscheinungen darstellen lassen. Die Grundfarben-Leuchten mit einer Peakwellenlänge im bevorzugten Bereich von 468 nm bis 483 nm beziehungsweise 570 nm bis 585 nm eignen sich insbesondere für gängige Kochfeldanwendungen.

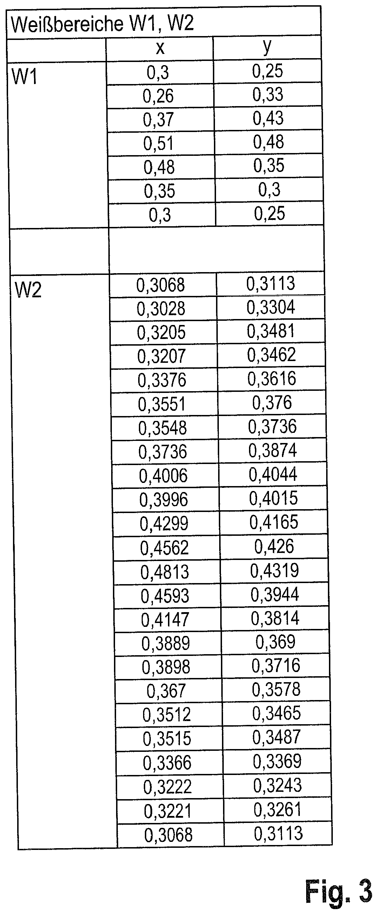

Erfindungsgemäß einen weißen Farbort darzustellen, heißt nicht, auf den Unbuntpunkt E beschränkt zu sein. Stattdessen toleriert das Auge einen weiten Farbortbereich als Weißeindruck. Dies hängt unter anderem auch von den Farborten der umgebenden Oberflächen ab, wie einer rot-schwarzen Kochfeldoberfläche. Ziel ist es daher, erfindungsgemäß zur Weiß-Kompensationen einen Farbort zu erreichen, der in den Grenzen des Weißbereiches W1 mit Farbtemperaturen zwischen 2000K und 10000K (CCT, color correlated temperature), vorzugsweise in den Grenzen des Weißbereiches W2 liegt. Der Weißbereich W2 umschließt hierbei die im ANSI definierte Weißfelder (ANSI binning) 1A, ..., 1D, ..., 8D, die typischerweise von LED-Herstellern herangezogen werden, um die Farborte ihrer weißen LEDs zu charakterisieren. Dieser Bereich entspricht Farbtemperaturen von 2580K bis 7040K, entsprechend einem Weißeindruck von Kaltweiß bis Warmweiß. Die Eckpunkte der erfindungsgemäß definierten Weißbereiche W1 und W2 in Figur 1 sind in Figur 3 aufgelistet.

Eine erfindungsgemäße Anzeige kann auch derart sein, dass auf oder im Bereich der Anzeigenseite und/oder der Rückseite ein oder mehrere Elemente angeordnet sind, die zumindest bereichsweise in dem von dem Leuchtelement erzeugten Anzeigenbereich angeordnet sind. Mit dieser Anzeige können Symbole, Schriftzüge etc. hinterleuchtet oder solche umleuchtet beziehungsweise ausgeleuchtet werden. Die Symbole, Zeichen und Flächen können hierbei durch Masken erzeugt werden, die auf dem Substrat fest aufgebracht sind oder zwischen Anzeigeeinheit und Substrat eingelegt sind oder Teil einer Umhausung der Anzeige sind.

Um das Licht der Grundfarben im Leuchtelement gleichmäßig zu durchmischen und damit eine homogene Anzeige zu erreichen, kann es vorgesehen sein, dass das Leuchtelement ein optisches Streuelement aufweist.

Bei einer erfindungsgemäßen Anzeige kann es vorgesehen sein, dass ein Lichtsensor einen Teil der auf der Anzeigenseite emittierten Lichts aufnimmt und dass insbesondere mittels einer Regeleinheit die spektrale Zusammensetzung des von dem Leuchtelement emittierten Lichtes änderbar ist. Mittels dieser Maßnahme können beispielsweise alterungsbedingte und temperaturbedingte Farbpunktverschiebungen kompensiert werden, aber auch speziell in Verbindung mit dem spektral inhomogenen transparenten Substrat vorgewählte, kompensierte Farbpunkte eingestellt werden. Weiterhin können vorgewählte Farbpunkte über eine Substratserie hinweg eingestellt werden, unabhängig von fertigungsbedingten Schwankungen des spektralen Transmissionsverlaufes einzelner Substrate.

Als schmalbandige Grundfarben-Lichtquellen kommen weiterhin entsprechende Laserdioden oder Laserlichtquellen in Frage.

Weiterhin ist es vorteilhaft, das Leuchtelement zumindest teilweise lichtdicht zu umhausen, um Streustrahlung und Fremdlichteinwirkung zu vermeiden.

Im Rahmen der Erfindung können auch thermochrome Effekte des Substrates mittels Farbpunktverschiebungen, insbesondere bei Einstellung eines Weißpunkts, dargestellt werden. Auftretende thermische Verschiebungen des Transmissionsspektrums des Substrats würden Verschiebungen des Farbortes der Anzeige vom Weißpunkt weg oder zum Weißpunkt hin hervorrufen, was für das Auge gut erkennbar ist.

Zur Erstellung komplexer Anzeigen kann es vorgesehen sein, dass mehrere Leuchtelemente eine Segmentanzeige bilden und dass jedes Leuchtelement drei Grundfarben-Leuchten aufweist, insbesondere dass die Leuchtelemente eine 7-Segment-Anzeige bilden. Wie bereits erwähnt, können Anzeigen mittels mindestens einer RGB-LED erstellt werden. Der Farbpunkt kann dabei beliebig im RGB-Dreieck gewählt werden, vorzugsweise ein Weißpunkt, so dass einfarbige, vorzugsweise weiße, Anzeigen darstellbar sind.

Für komplexe Anzeigen wie Farbdisplays (beispielsweise LCD, TFT) können auch Lösungen bereitgestellt werden.

Es ist allerdings keine denkbare Variante, schmalbandige Farbfilter in den Displays bei beibehaltener weißer Hinterleuchtung zu verwenden. Dies stellt zwar sicher, dass das aufgespannte Farbpolygon beibehalten wird, also die Farborte der Grundfarben nicht verschoben werden, aber die durch das Substrat hervorgerufenen Helligkeitsunterschiede der Grundfarben werden nicht kompensiert. Dies führt zu Farbverschiebungen der farbigen Anzeige.

Hingegen ist eine Farbortverschiebung der Hinterleuchtung eines Displays mit Farbfiltern eine weitere erfindungsgemäße Variante. Die Hinterleuchtung wird über mindestens ein RGB-Leuchtelement bereitgestellt. Hierbei wird der Farbort der Hinterleuchtung so eingestellt, dass die Farbortverschiebung durch das Substrat kompensiert wird. Dies lässt sowohl den Weißpunkt der Anzeige als auch dessen Grundfarben nahezu am ursprünglichen Farbort, wie bei einem neutralen spektral einheitlich transmittierenden Substrat. Kleine, aber vernachlässigbare Abweichungen treten hierbei durch nicht-lineare Effekte zwischen den beiden Filtern, dem Substrat und den Grundfarbenfiltern auf. Die nicht-linearen Effekte treten durch die Multiplikation der beiden Filtertransmissionsspektren unter dem Wellenlängenintegral in den X, Y, Z-Funktionen des CIExyY Formalismus auf.

Weiterhin sind insbesondere Farbdisplays ohne Farbfilter, deren Hinterleuchtung pixelweise über mindestens ein sequentiell angesteuertes Leuchtelement bereitgestellt wird, verwirklichbar. Der durch das Substrat verschobene Weißabgleich wird durch die Korrektur der Grundhelligkeiten der Grundfarben-Leuchten kompensiert. Die sequentielle Ansteuerung der Grundfarben und der einzelnen Leuchtelement erlaubt dann eine Farbdarstellung und Grauwertregulierung, wie es bei sequentiellen Displays darstellbar ist. Nicht-lineare Effekte wie bei einem Display, beruhend auf Farbfilter und einem korrigierten Farbort der Hinterleuchtung, treten hier nicht auf. Zumal werden Intensitätsverluste durch die Filter vermieden.

Es werden somit mit erfindungsgemäß verbundenen Substraten zwei erfindungsgemäße Lösungen für den Einsatz von Farbdisplays bereitgestellt. Zum einen wird bei Displays mit Farbfiltern eine Farbkorrektur der Hintergrundbeleuchtung angewendet, zum anderen können bei Displays ohne Farbfilter die Farbteilbilder in bekannter Weise sequentiell angesteuert werden, wobei die Grundfarbintensitäten der pixelweisen RGB-Leuchten korrigiert werden müssen, so dass der Weißpunkt des Displays korrigiert ist (Weißabgleich).

Die Erfindung wird im Folgenden anhand von in den Zeichnungen dargestellten Ausführungsbeispielen näher erläutert. Es zeigen:
Figur 1 ein CIE/1931-Diagramm beispielhaft mit genormtem sRGB, Adobe RGB, wg-RGB Farbräumen, Norm-Weißpunkten und definierten Weißbereichen W1 und W2;
Figur 2 eine vergrößerte Detaildarstellung des Diagramms gemäß Figur 1;
Figur 3 die Koordination der in den Figuren 1 und 2 angegebenen Weißbereiche;
Figur 4 in schematischer Darstellung und in Seitenansicht ein Glaskeramik-Kochfeld mit einer Anzeige;
Figur 5 eine handelsübliche 7-Segement-Anzeige in schematischer Dar¬stellung;
Figur 6 eine RGB-Ausgestaltungsvariante der 7-Segement-Anzeige;
Figur 7 ein Diagramm, bei dem die relative Intensität (Transmission über der Wellenlänge) des Lichtes im Spektralbereich dargestellt ist; und
Figur 8 ein CIE/1931-Diagramm mit beispielhaften Farb-LED-Paaren eines Leuchtelementes.

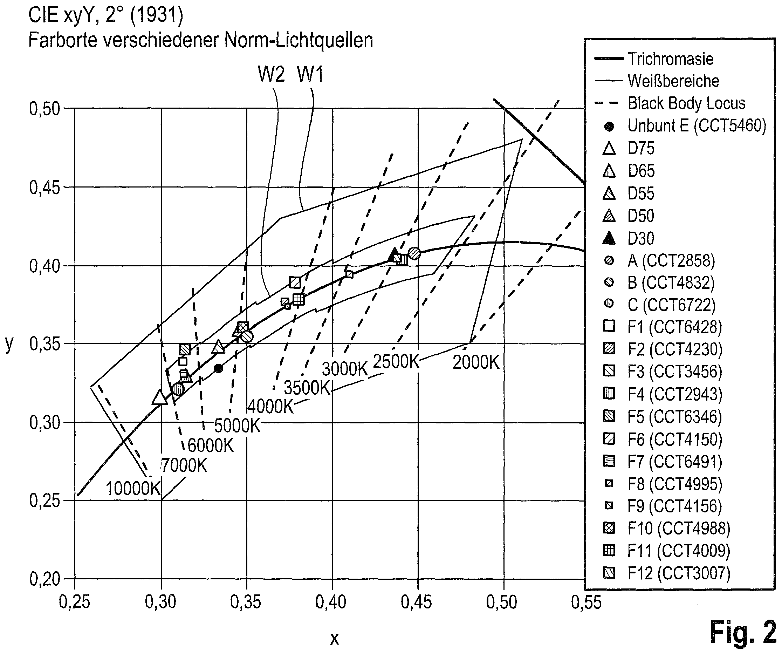

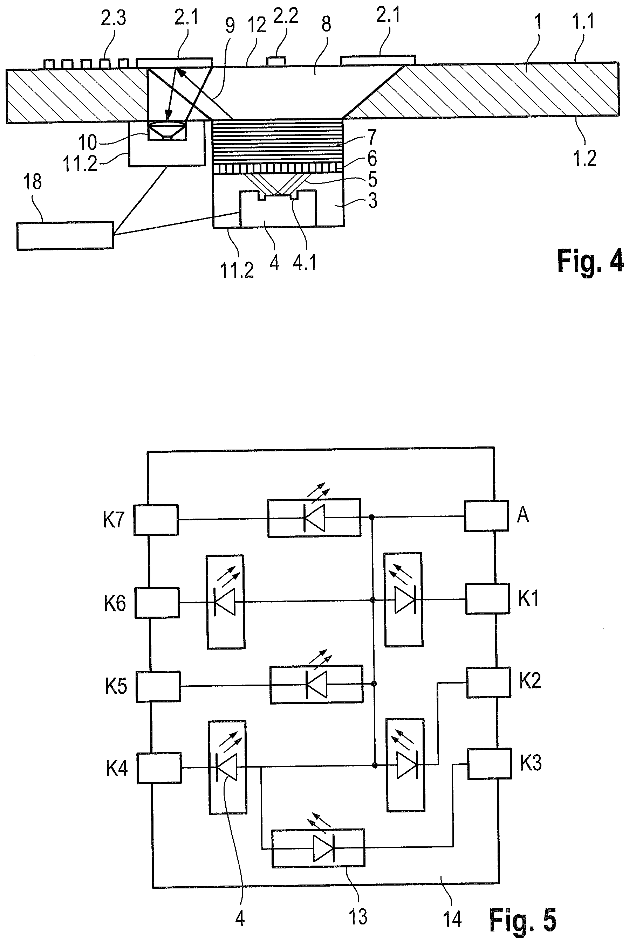

Figur 4 zeigt ein Kochfeld mit einem Substrat 1, bestehend aus Glaskeramik-Material mit einer Transmission zwischen 0,1% und 40% (vorzugsweise 25%) im Spektralbereich zwischen 400 nm und 700 nm. Die Glaskeramik ist eingefärbt und teiltransparent. Dabei ist die Transmission im Spektralbereich inhomogen. Im vorliegenden Ausführungsbeispiel ist das Transmissionsverhalten so gewählt, dass das Substrat für die drei Grundfarben Rot, Grün, Blau des RGB-Dreiecks gemäß dem CIE-Farbraum (CIE-Commission International de l'eclairage, Normvalenzsystem (siehe Figuren 1 und 2)) unterschiedlich durchlässig ist. Für solche farbige, teiltransparente Substrate 1, insbesondere für solche, bei denen die Transmissionswerten zwischen 0,1% und 40% (vorzugsweise 25%) im Spektralbereich zwischen 400 nm und 700 nm und die relativen Transmissionsunterschiede d_{T} im Wellenlängenbereich zwischen 470 nm und 630 nm von d_{T} > 50%, bevorzugt d_{T} > 80%, bevorzugt 95% > d_{T} > 80% aufweisen, sollen weiße und, im Farbraum des entsprechenden CIE-Polygons, farbige Anzeigen, insbesondere Dekorbeleuchtung/Displays, bereitgestellt werden. Das Substrat 1 weist eine obere, dem Betrachter zugewandte Anzeigeseite 1.1 und eine untere Rückseite 1.2 auf. Im Bereich der Rückseite 1.2 sind (die in Figur 1 nicht dargestellten) Heizelemente, elektrische Leiter, Befestigungen etc. des Kochfeldes angeordnet. Infolge der Blickdichtigkeit des Substrats 1 ist der Einblick auf diese Bauelemente versperrt. Die Anzeigeseite 1.1 bildet die Sicht- und Funktionsfläche, auf der Kochgeschirr aufgestellt werden kann. Auf der Anzeigeseite 1.1 sind Dekorelemente 2.1 bis 2.3 aufbeschichtet und fest mit dem Substrat 1 verbunden. Die Dekorelemente 2.1 bis 2.3 werden beispielsweise von in das Substrat 1 eingebrannten keramischen Farben gebildet. Die Dekorelemente 2.3 bilden, wie aus dem Stand der Technik bekannt, Kochzonenmarkierungen. Die Dekorelemente 2.1 und 2.2 bilden ein Dekor, das mit der Anzeige beleuchtet wird. Eines der Dekorelemente 2.1 (das in Figur 2 linke) bildet gleichzeitig ein Reflektionselement.

Im Bereich der Rückseite 1.2 ist ein Leuchtelement 4 angeordnet, das von einer RGB-LED gebildet wird. Dieses Leuchtelement 4 weist als Grundfarben-Leuchten 4.1 eine rotes, eine grünes und eine blaues Licht emittierende LED auf. Das Leuchtelement 4 emittiert während des Betriebes einen Lichtkegel 5, der durch eine Streuscheibe 6 geleitet wird. Durch diese Streuscheibe 6 wird das Licht der RGB-LEDs im austretenden Lichtfeld 7 gleichmäßig und homogen durchmischt, so dass nach der Streuscheibe 6 am Substrat 1 ein homogener Farbeindruck entsteht. Um eine Änderung der Zusammensetzung des Lichtfeldes 7 zu verhindern, ist eine lichtdichte Umhausung 11.2 verwendet, die das Leuchtelement 4, die Streuscheibe 6 und den gesamten Lichtweg unter dem Substrat 1 gegenüber der Umgebung abschirmt. Das gemischte Licht des Lichtfeldes 7 wird in Form eines Lichtkegels 8 durch das Substrat 1 geleitet und auf der Anzeigenseite 1.1 emittiert. Dabei wird das Dekorelement 2.2 umleuchtet. Die Dekorelemente 2.1 bilden beispielsweise einen Rahmen, der ausgeleuchtet wird.

Das von dem Leuchtelement 4 ausgestrahlte ("Gesamt-") Licht ist bezüglich der RGB-Zusammensetzung so beschaffen, dass durch eine Anpassung der Grundfarbenhelligkeiten der einzelnen Grundfarben-Leuchten 4.1 die uneinheitliche Transmission des Substrates 1 kompensiert wird. Damit entsteht auf der Anzeigenseite der gewünschte Farbeindruck. Insbesondere lässt sich eine optisch ansprechende Weißlicht-Darstellung erzeugen.

An dem linken Dekorelement 2.1 wird das Licht des Lichtkegels 8 auf der Anzeigenseite 1.1 reflektiert und durch das Substrat 1 hindurch wieder zur Rückseite 1.2 geleitet. Dort ist ein Licht-Sensor 10 angeordnet. Der Licht-Sensor 10 ist in einer lichtdichten Umhausung 11.1 untergebracht.

Der Lichtsensor 10 nimmt Teile des Lichtes der emittierten Grundfarben (RGB) nach Durchgang durch das Substrat 1 auf. Mittels einer Regeleinheit 18, wie sie beispielsweise bei der Anzeige gemäß Figur 4 verwendet ist, können alterungs- und/oder temperaturbedingte Farbpunktverschiebungen kompensiert werden.

Figur 5 zeigt eine handelsübliche 7-Segment-Anzeige 14, bei der nun sieben, vorzugsweise baugleiche, LEDs als Leuchtelemente 4 eingebaut sind. Die Leuchtelemente 4 bilden jeweils ein Leuchtsegment 13 und sind, wie bei 7-Segement-Anzeigen üblich, in Form einer 8 gruppiert. Ein einfacher Schaltungsaufbau wird dadurch erreicht, dass sämtliche Leuchtelemente 4 an eine gemeinsame Anode A und jeweils an eine eigene Kathode K1 bis K7 angeschlossen sind.

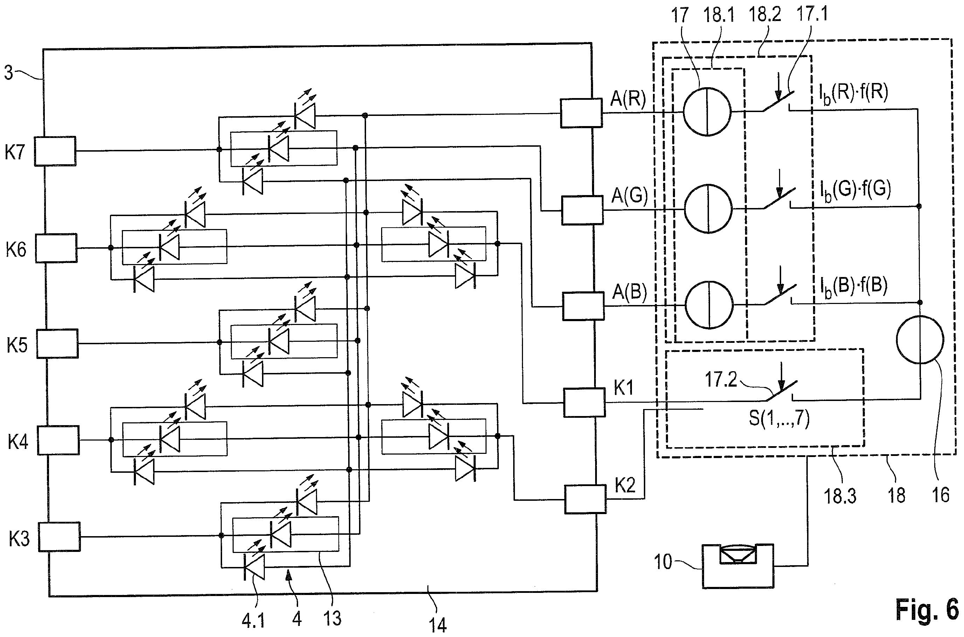

Figur 6 zeigt eine Modifikation der in Figur 5 veranschaulichten 7-Segment-Anzeige 14. Dabei weist die Anzeige 14 sieben vorzugsweise baugleiche RGB-LEDs in Form von Leuchtsegmenten 13 auf. Diese RGB-LEDs entsprechen jeweils denen gemäß Figur 4. Jedes RGB-Leuchtsegment 13 ist wieder individuell an eine Kathode K1-7 angeschlossen. Dabei sind die Kathoden der einzelnen RGB-LEDs zusammengeschaltet. Die einzelnen farblichen Grundfarben-Leuchten 4.1 sind jeweils gemeinsam an eine Anode A (R), A (G) und A (B) angeschaltet. Anodenseitig sind beschaltbare oder ansteuerbare Stromtreiber 17 und Schalter 17.1 einer Regeleinheit 18 vorgesehen, die in einen Stromkreis mit einer Spannungsquelle 16 einbezogen sind. In einem Regelblock 18.1 wird mittels beschaltbarer Stromtreiber 17 der gewünschte anzeigenseitige Farbort durch vorgewählte Basis-Stromstärken Ib(R,G,B) fest eingestellt, der entweder einem gewünschten Farbeindruck oder einem kompensierten Farbort entspricht oder einen festen Weißabgleich für eine Farbanzeigenanwendung (hier nicht dargestellt) bereitstellt. In einem Regelblock 18.2 kann die Regelung die festen Farborteinstellungen korrigieren, beispielsweise aufgrund eines Fehlersignals des Sensors 10, oder eine gewünschte Helligkeit einregeln oder einen anderen Farbort für jedes einzelne Leuchtelement einstellen, insbesondere bei Farbanzeigen oder einfarbigen Anzeigen mit wechselnden Farborten. Sowohl die Einstellungen der Helligkeit (Grauwert) als auch des Farborts kann beispielsweise über eine übliche Pulsweite nmodulation (PWM) mittels der Schalter 17.1 über einen mittleren Abschwächungsfaktor f(R,G,B) geschehen oder über programmierbare Stromtreiber 17 durchgeführt werden. Der mittlere Strom lb(R,G,B)·f(R,G,B) steuert wählbare Grundhelligkeit der Grundfarbelemente (4.1) an. Während eines vollen Schaltzyklus steuert ein Regelblock 18.3 die gewählten Ein/Aus-Schaltzustände der Schalter S(1,..,7) 17.2 für die Kathodenanschlüsse K1-K7, um das entsprechende 7-Segment-Symbol darzustellen. Die Grundhelligkeiten können gegebenenfalls bei einer sequentiellen Ansteuerung der Leuchtelemente 4 über den Regelblock 18.3 weiter herabgesetzt sein.

Dieser Aufbau einer RGB-7-Segment-Anzeige führt zu minimal 9 Anschlüssen. Ein anderer Aufbau wäre mit einer einzelnen gemeinsamen Anode A und jeweils 3 Kathoden K(R), K(G), K(B) Anschlüssen pro Leuchtsegment 13. Dies führt zu insgesamt 22 Anschlüssen. Die Farborte und Helligkeiten sind dann für jedes Leuchtsegment 13 individuell regelbar. Entsprechende Anzeigen sind auch mit gemeinsamen Kathoden darstellbar. Die Regeleinheit 18 kann vorteilhaft mit einem Lichtsensor 10 verknüpft sein. Wenn nun beispielsweise wie oben erwähnt, alterungsbedingt oder infolge von Temperaturänderungen auf der Anzeigenseite 1.1 eine Verschiebung des voreingestellten Farbortes entsteht, so wird dies vom Lichtsensor 10 detektiert. In einem Regelkreis der Regeleinheit 18.2 wird die PWM dann so eingestellt, dass über eine Regelung des mittleren Stromverhältnisses zwischen den RGB Grundfarben-Leuchten 4.1 eine Änderung des Mischungsverhältnisses des von den Leuchtsegmenten 13 emittierten Lichtes stattfindet. Dabei erfolgt diese Regelung elektronisch beispielsweise so, dass mit tabellarisch hinterlegten Farbmischungsverhältnissen die Farbpunktverschiebung kompensiert wird.

Selbstverständlich ist das vorbeschriebene Regelschema nicht auf eine 7-Segment-Anzeige 14 beschränkt, sondern kann bei jeder anderen erfindungsgemäßen Anzeige ebenfalls zum Einsatz kommen.

Beispielsweise kann der gewünschte anzeigenseitige Farbort einer einfarbigen LCD-Anzeige in Regelblock 18.1 eingestellt werden, insbesondere beispielsweise wieder zu weiß. Durch den Regelblock 18.2 kann vorteilhaft ein Farbfehlersignal eines Sensors 10 korrigiert werden. Auch kann hier der Farbort einer einfarbigen Anzeige verändert werden, so dass zusätzliche mit Farben verknüpfte Informationsinhalte vermittelt werden können.

Ganz entsprechend kann der Farbort einer Farb-LCD-Anzeige, deren Grundfarbenerzeugung auf Farbfilter beruhen, mit Regelblock 18.1 auf einen anzeigenseitig gewünschten Weißpunkt eingestellt werden und über Regelblock 18.2 fortlaufend korrigiert werden oder verändert werden.

Weiterhin können eingangs erwähnte sequentielle Farbdisplays gemäß Figur 6 derart bereitgestellt werden, dass der durch das Substrat 1 verschoben erscheinende Farbort des Displays durch den Regelblock 18.1 für alle Pixel-RGB-Leuchtelemente auf einen anzeigenseitig gewünschten Weißpunkt eingestellt werden. Regelblock 18.2 übernimmt die Farbkorrekturen aufgrund von Fehlersignalen eines Sensors 10 oder die Einstellung alternativer Farborte (Weißpunkte). Insbesondere werden über den Regelblock 18.2 mittels Schalter 17.1 die Grundfarben zur Aktivierung der Teilfarbbilder sequentiell geschaltet. Optionale Zeilenschaltungen können über Regelblock 18.2 mittels Schalter 17.1 oder Regelblock 18.3 mittels Schalter 17.2 realisiert werden. Der Bildinhalt in Form von Grauwerten für jede einzelne Grundfarbe wird über die LCD-Anzeige generiert.

In beiden Ausführungsformen eines Farbdisplays erhält man wieder den vollen Farbeindruck eines Farbdisplays, insbesondere erscheint Weiß wieder als Weiß, wie durch ein farbneutrales Substrat 1.

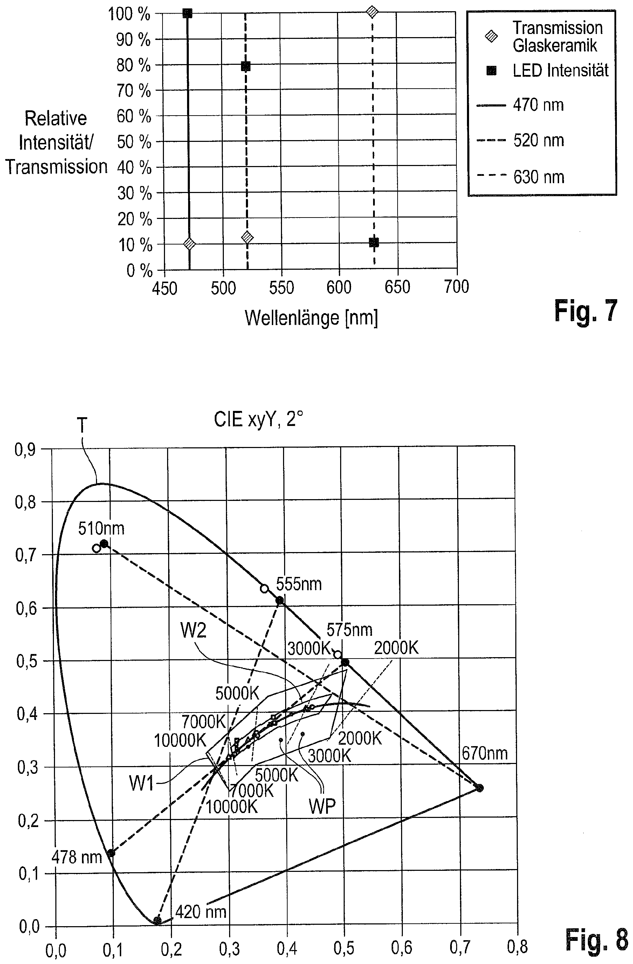

Typische, beispielhafte relative Transmissionswerte für die Glaskeramik der SCHOTT AG CERAN HIGHTRANS eco ® sind in Figur 7 für dieses Material veranschaulicht. Dort ist die relative Intensität des Lichtes über der Wellenlänge des Lichtes für einzelne Wellenlängen im Bereich zwischen 450 nm und 700 nm aufgetragen. Dabei wählt man die Grundfarbe des RGB-Systems als Bezugswert, für die das Substrat 1 die höchste Transmission (geringste Absorption) aufweist und setzt dafür den relativen Transmissionswert auf 100%. Im vorliegenden Fall weist das Substrat 1 für die Farbe Rot (Wellenlänge 630 nm) die höchste Transmission auf. In Bezug dazu beträgt die relative Transmission für Grün und Blau 12,1% und 9,6% (520 nm und 470 nm). Die RGB-Intensitäten einer ideal monochromatischen RGB-Leuchte müssten dann relativ 9,6% (Rot), 78,9% (Grün) und 100% (Blau) betragen, um die spektral, inhomogene Transmission des Substrates zu kompensieren. Die genau erforderlichen Intensitätsverhältnisse hängen von der spektralen Breite der einzelnen RGB-Leuchten ab und müssen über die XYZ-Integrale des CIExyY Formalismus berechnet werden.

Mit Bezugnahme auf Figur 8 wird ein weiteres, vorteilhaftes vereinfachtes Leuchtelement beschrieben. Das Leuchtelement ist dabei derart ausgestaltet, dass es nur zwei Grundfarbenleuchten umfasst, die beispielhaft als Farb-LEDs ausgeführt sind. Zwei Farb-LEDs spannen einen Farbraum auf, der durch die Verbindungslinie deren Farborte im CIExyY-Diagramm dargestellt werden kann, wie dies Figur 8 veranschaulicht. Die Farborte liegen wieder innerhalb oder auf der Trichromasiekurve T. Auch bei einer Zwei-Leuchtelemente-Anordnung kann bei geeigneter Wahl derer Emissionswellenlängen ein weißer Farbort, insbesondere auch ein normierter Weißpunkt W, eingestellt werden, es kann sogar durch eine Steuerung deren Intensitätsverhältnisse der weiße Farbort zwischen warm und kalt Weiß verändert werden. Eine Zwei-Leuchtelemente-Anordnung ist gegenüber einer Drei-Leuchtelemente-Anordnung (beispielsweise RGB) insofern vorteilhaft, als sich die Baugrößen der Leuchtelemente kleiner realisieren lassen, beispielhaft in Ausführung einer 7-Segment Anzeige. Die kleinstmögliche Anzeigengröße einer 7-Segmentanzeige ist durch die Anzahl der Grundfarbenleuchten (beispielsweise LEDs) in einem Segment bestimmt. Derzeit lassen sich für Zwei-LED-Anordnungen kleinste Anzeigenhöhen von 13mm, für Drei-LED-Anzeigen von 20mm realisieren. Vorzugsweise soll eine Zwei-Leuchtelemente-Anordnung realisiert werden, die im CIExyY(2°)-Diagramm (vgl. Figur 8) den Weißbereich W1 oder den Weißbereich W2 (ANSI_NEMA_ANSLG C78.377-2008) schneidet oder tangiert, vorzugsweise die Planckfarbkurve (Planck Locus) schneidet oder tangiert. Bevorzugt werden paarweise zwei Farb-LEDs als Zwei-Leuchtelemente-Anordnung realisiert, die Peakwellenlängen von nm und nm, vorzugsweise von nm und nm, aufweisen. In Figur 8 sind beispielhafte LED-Paare mit deren Peakwellenlängen beschriftet dargestellt, die grauen Kreissymbole lokalisieren die Farborte des LED-Lichtes direkt betrachtet, die schwarzen Kreissymbole lokalisieren die Farborte des LED-Lichtes durch eine CERAN HIGHTRANS® eco Probe betrachtet. Da die Farb-LEDs typischerweise eine spektrale Halbwertsbreite von nur 20-25 nm aufweisen, kommt es durch die spektral inhomogene Filtereigenschaft der Glaskeramik nur zu einer geringen Farbortverschiebung bei Betrachtung durch die Glaskeramik im Vergleich zum direkt beobachteten LED-Licht. Die gestrichelten Linien zwischen den LED-Paaren stellen den realisierbaren Farbraum (Farbortlinie) der LED-Paare dar.

Mit den erfindungsgemäßen Anzeigen können beispielsweise thermochrome Heißanzeigen verwirklicht werden, die auch im heißen Kochzonenbereich eine Betriebszustands-Anzeige ermöglichen.

Denkbar ist es auch, dass dabei das RGB-Licht eines oder mehrerer Leuchtelemente 4 in Licht-Leitfasern, insbesondere Glasfasern, eingespeist und an die gewünschte Stelle der Rückseite 1.2 in das Substrat 1 eingekoppelt wird.

Die Erfindung ist nicht auf die beschriebenen Ausführungsbeispiele beschränkt. Die erfindungsgemäßen Anzeigen können insbesondere auch zur Hinterleuchtung farbiger Architekturgläser eingesetzt werden.

## Patentansprüche

1. Kochfeld mit einer Anzeige und einem Substrat (1), wobei das Substrat (1) zumindest teilweise aus einem teiltransparentem Werkstoff mit spektral inhomogenem Transmissionsverlauf besteht, wobei das Substrat (1) eine Anzeigeseite (1.1) und eine Rückseite (1.2) aufweist, wobei im Bereich der Rückseite (1.2) wenigstens ein Leuchtelement (4) angeordnet ist, und wobei das Leuchtelement (4) mindestens zwei Grundfarben-Leuchten (4.1) aufweist, **dadurch gekennzeichnet,**
**dass** die Grundfarbenhelligkeit von wenigstens einer der Grundfarben-Leuchten (4.1) korrigiert ist,
**dass** die maximale Transmission des das Substrat bildenden Glaskeramikkörpers < 40% im Spektralbereich von 400nm bis 700 nm und im Mittel < 4 % im Spektralbereich von 450nm bis 600 nm beträgt,
und **dass** mittels einer Regeleinheit (18) die spektrale Zusammensetzung des von dem Leuchtelement (4) emittierten Lichtes voreinstellbar und veränderbar ist,
oder dass die Grundfarben-Leuchten (4.1) des Leuchtelementes (4) von sequentiell angesteuerten LED's gebildet sind.

2. Kochfeld nach Anspruch 1,
**dadurch gekennzeichnet,**
**dass** das Substrat im Wellenlängenbereich zwischen 470nm und 630nm einen Transmissionsunterschied d_{T} > 50% aufweist.

3. Kochfeld nach Anspruch 2,
**dadurch gekennzeichnet,**
**dass** das Substrat im Wellenlängenbereich zwischen 470nm und 630nm einen Transmissionsunterschied d_{T} > 80% aufweist.

4. Kochfeld nach Anspruch 3,
**dadurch gekennzeichnet,**
**dass** das Substrat im Wellenlängenbereich zwischen 470nm und 630nm eine Transmissionsunterschied 95% > d_{T} > 80% aufweist.

5. Kochfeld nach Anspruch einem der Ansprüche 1 bis 4,
**dadurch gekennzeichnet,**
**dass** die relative Transmission des Substrats (1) bei einer Wellenlänge von 520nm im Bereich zwischen 9% und 15% und bei einer Wellenlänge von 470nm zwischen 7% und 13% relativ zur Transmission bei einer Wellenlänge von 630nm beträgt.

6. Kochfeld nach einem der vorhergehenden Ansprüche,
**dadurch gekennzeichnet,**
**dass** die mittlere Transmission des Glaskeramikkörpers > 0,2 % jeweils für jeden der Spektralbereiche von 420-500nm, 500-620nm und 550-640nm beträgt.

7. Kochfeld nach Anspruch 6,
**dadurch gekennzeichnet,**
**dass** die mittlere Transmission des Glaskeramikkörpers > 0,4 % jeweils für jeden der Spektralbereiche von 420-500nm, 500-620nm und 550-640nm beträgt.

8. Kochfeld nach einem der vorhergehenden Ansprüche,
**dadurch gekennzeichnet,**
**dass** die maximale Transmission des Glaskeramikkörpers < 40% im Spektralbereich von 400nm bis 750nm und < 4 % im Spektralbereich von 450nm bis 600nm beträgt.

9. Kochfeld nach Anspruch 8,
**dadurch gekennzeichnet,**
**dass** die maximale Transmission des Glaskeramikkörpers < 25 % im Spektralbereich von 400 bis 750nm und < 4 % im Spektralbereich von 450 bis 600nm beträgt.

10. Kochfeld nach einem der vorhergehenden Ansprüche,
**dadurch gekennzeichnet,**
**dass** das Leuchtelement (4) drei Grundfarben-Leuchten (4.1) umfasst, wobei eine zwischen dominanten Wellenlängen von 580nm und 750nm, eine zweite zwischen 480nm und 590nm und eine dritte zwischen 400nm und 505nm Licht emittiert.

11. Kochfeld nach Anspruch 10,
**dadurch gekennzeichnet,**
**dass** das Leuchtelement (4) drei Grundfarben-Leuchten (4.1) umfasst, die bei den dominanten Wellenlängen 470nm, 520nm und 630nm mit einer Abweichung der dominanten Wellenlänge von ±5nm Licht emittieren.

12. Kochfeld nach einem der Ansprüche 1 bis 9,
**dadurch gekennzeichnet,**
**dass** das Leuchtelement (4) zwei Grundfarben-Leuchten (4.1) umfasst, und dass die Verbindungslinie der Farborte dieser Grundfarben-Leuchten (4.1) im CIExyY-Diagramm (2° Observer) den Weißbereich W1, insbesondere den Weißbereich W2, schneidet oder tangiert, besonders bevorzugt die Planckfarbkurve schneidet.

13. Kochfeld nach Anspruch 12,
**dadurch gekennzeichnet,**
**dass** die Peakwellenlänge einer der beiden Grundfarben-Leuchten (4.1) im Bereich zwischen 420nm und 510nm, besonders bevorzugt im Bereich zwischen 468nm und 483nm, beträgt, und/oder
**dass** die Peakwellenlänge einer der beiden Grundfarben-Leuchten (4.1) im Bereich zwischen 550nm und 670nm, besonders bevorzugt im Bereich zwischen 570nm und 585nm beträgt.

14. Kochfeld nach einem der vorhergehenden Ansprüche,
**dadurch gekennzeichnet,**
**dass** das Leuchtelement (4) ein optisches Streuelement (6) aufweist.

15. Kochfeld nach einem der vorhergehenden Ansprüche,
**dadurch gekennzeichnet,**
**dass** auf oder im Bereich der Anzeigenseite (1.1) und/oder der Rückseite (1.2) ein oder mehrere Elemente (2.1, 2.2) angeordnet sind, die zumindest bereichsweise in dem von dem Leuchtelement (4) erzeugten Anzeigenbereich angeordnet sind.

16. Kochfeld nach einem der vorhergehenden Ansprüche,
**dadurch gekennzeichnet,**
**dass** ein Lichtsensor (10) einen Teil der auf der Anzeigenseite (1.1) emittierten Lichts aufnimmt.

17. Kochfeld nach einem der vorhergehenden Ansprüche, **dadurch**
**gekennzeichnet,**
**dass** das Leuchtelement (4) Grundfarben-Leuchtelemente (4.1) aufweist, mittels derer die Grundfarben eines Farbpolygons erzeugbar sind, so dass auf der Anzeigenseite (1.1) des Substrats (1) ein Farbpolygon darstellbar ist, welches mindestens teilweise den Weißbereichs W1, vorzugsweise teilweise den Weißbereichs W2 enthält mit den CIExyY (1931) Koordinaten:
| **Weißbereiche W1, W2** | | | | | |
|---|---|---|---|---|---|
| | **x** | **y** | | **x** | **y** |
| **W1** | 0,3 | 0,25 | **W2** | 0,3068 | 0,3113 |
| | 0,26 | 0,33 | | 0,3028 | 0,3304 |
| | 0,37 | 0,43 | | 0,3205 | 0,3481 |
| | 0,51 | 0,48 | | 0,3207 | 0,3462 |
| | 0,48 | 0,35 | | 0,3376 | 0,3616 |
| | 0,35 | 0,3 | | 0,3551 | 0,376 |
| | 0,3 | 0,25 | | 0,3548 | 0,3736 |
| | | | | 0,3736 | 0,3874 |
| | | | | 0,4006 | 0,4044 |
| | | | | 0,3996 | 0,4015 |
| | | | | 0,4299 | 0,4165 |
| | | | | 0,4562 | 0,426 |
| | | | | 0,4813 | 0,4319 |
| | | | | 0,4593 | 0,3944 |
| | | | | 0,4147 | 0,3814 |
| | | | | 0,3889 | 0,369 |
| | | | | 0,3898 | 0,3716 |
| | | | | 0,367 | 0,3578 |
| | | | | 0,3512 | 0,3465 |
| | | | | 0,3515 | 0,3487 |
| | | | | 0,3366 | 0,3369 |
| | | | | 0,3222 | 0,3243 |
| | | | | 0,3221 | 0,3261 |
| | | | | 0,3068 | 0,3113 |

18. Kochfeld nach einem der vorhergehenden Ansprüche,
**dadurch gekennzeichnet,**
**dass** das Leuchtelement (4) Grundfarben-Leuchtelemente (4.1) aufweist, mittels derer die Grundfarben eines Farbpolygons erzeugbar sind, so dass auf der Anzeigenseite (1.1) des Substrats (1) ein Farbpolygon darstellbar ist, welches den Unbuntpunkt x=1/3, y=1/3 (CIExyY 2°,1931) enthält.

19. Kochfeld nach einem der vorhergehenden Ansprüche,
**dadurch gekennzeichnet,**
**dass** das Leuchtelement (4) als Grundfarben-Leuchten (4.1) weiße, blaue oder UV-Leuchtelemente in Kombination mit schmalbandigen Farbfiltern oder in Kombination mit Farblumineszenzmaterialien aufweist.

20. Kochfeld nach einem der vorhergehenden Ansprüche,
**dadurch gekennzeichnet,**
**dass** das Leuchtelement (4) als Grundfarben-Leuchten (4.1) Laserdioden oder Lichtleitquellen aufweist.

21. Kochfeld nach einem der vorhergehenden Ansprüche,
**dadurch gekennzeichnet,**
**dass** das Leuchtelement (4) zumindest bereichsweise von einer lichtdichten Umhausung (11.2) abgeschottet ist.

22. Kochfeld nach einem der vorhergehenden Ansprüche,
**dadurch gekennzeichnet,**
**dass** mehrere Leuchtelemente (4) eine Segmentanzeige bilden, und dass jedes Leuchtelement (4) mindestens zwei, vorzugsweise drei Grundfarben-Leuchten (4.1) aufweist.

23. Kochfeld nach einem der Ansprüche 1 bis 22,
**dadurch gekennzeichnet,**
**dass** die Leuchtelemente (4) eine Sieben-Segment-Anzeige bilden.

24. Kochfeld nach einem der vorhergehenden Ansprüche,
**dadurch gekennzeichnet,**
**dass** die Leuchtelemente (4) Pixel eines Farbdisplays bilden.

25. Kochfeld nach einem der vorhergehenden Ansprüche,
**dadurch gekennzeichnet,**
**dass** die Leuchtelemente (4) die Lichtquelle eine Hintergrundbeleuchtung eines einfarbigen Displays (beispielsweise eines LCD) bilden.

26. Kochfeld nach einem der vorhergehenden Ansprüche,
**dadurch gekennzeichnet,**
**dass** die Leuchtelemente (4) die Lichtquelle eine Hintergrundbeleuchtung eines farbigen Displays (beispielsweise eines LCD oder TFT) bilden.

## Claims

1. Hob comprising a display and a substrate (1), wherein the substrate (1) at least partly consists of a partly transparent material having a spectrally inhomogeneous transmission profile, wherein the substrate (1) has a display side (1.1) and a rear side (1.2), wherein at least one illuminant (4) is arranged in the region of the rear side (1.2), and wherein the illuminant (4) comprises at least two primary colour luminaires (4.1),
**characterized**
**in that** the primary colour brightness of at least one of the primary colour luminaires (4.1) is corrected,
**in that** the maximum transmission of the glass ceramic body forming the substrate is <40% in the spectral range of 400 nm to 700 nm and on average <4% in the spectral range of 450 nm to 600 nm,
and **in that** the spectral composition of the light emitted by the illuminant (4) is presettable and variable by means of a control unit (18),
or in that the primary colour luminaires (4.1) of the illuminant (4) are formed by sequentially driven LEDs.

2. Hob according to Claim 1,
**characterized**
**in that** the substrate has a transmission difference d_{T} >50% in the wavelength range of between 470 nm and 630 nm.

3. Hob according to Claim 2,
**characterized**
**in that** the substrate has a transmission difference d_{T} >80% in the wavelength range of between 470 nm and 630 nm.

4. Hob according to Claim 3,
**characterized**
**in that** the substrate has a transmission difference 95% > d_{T} >80% in the wavelength range of between 470 nm and 630 nm.

5. Hob according to Claim any of Claims 1 to 4,
**characterized**
**in that** the relative transmission of the substrate (1) is in the range of between 9% and 15% at a wavelength of 520 nm and between 7% and 13% at a wavelength of 470 nm relative to the transmission at a wavelength of 630 nm.

6. Hob according to any of the preceding claims,
**characterized**
**in that** the average transmission of the glass ceramic body is >0.2% in each case for each of the spectral ranges of 420-500 nm, 500-620 nm and 550-640 nm.

7. Hob according to Claim 6,
**characterized**
**in that** the average transmission of the glass ceramic body is >0.4% in each case for each of the spectral ranges of 420-500 nm, 500-620 nm and 550-640 nm.

8. Hob according to any of the preceding claims,
**characterized**
**in that** the maximum transmission of the glass ceramic body is <40% in the spectral range of 400 nm to 750 nm and <4% in the spectral range of 450 nm to 600 nm.

9. Hob according to Claim 8,
**characterized**
**in that** the maximum transmission of the glass ceramic body is <25% in the spectral range of 400 nm to 750 nm and <4% in the spectral range of 450 nm to 600 nm.

10. Hob according to any of the preceding claims,
**characterized**
**in that** the illuminant (4) comprises three primary colour luminaires (4.1), wherein one emits light between dominant wavelengths of 580 nm and 750 nm, a second between 480 nm and 590 nm and a third between 400 nm and 505 nm.

11. Hob according to Claim 10,
**characterized**
**in that** the illuminant (4) comprises three primary colour luminaires (4.1), which emit light at the dominant wavelengths of 470 nm, 520 nm and 630 nm with a deviation of the dominant wavelength of ±5 nm.

12. Hob according to any of Claims 1 to 9,
**characterized**
**in that** the illuminant (4) comprises two primary colour luminaires (4.1), and
**in that** the connecting line of the colour loci of said primary colour luminaires (4.1) in the CIExyY diagram (2° Observer) intersects or is tangent to the white region W1, in particular the white region W2, particularly preferably intersects the Planckian locus.

13. Hob according to Claim 12,
**characterized**
**in that** the peak wavelength of one of the two primary colour luminaires (4.1) is in the range of between 420 nm and 510 nm, particularly preferably in the range of between 468 nm and 483 nm, and/or in that the peak wavelength of one of the two primary colour luminaires (4.1) is in the range of between 550 nm and 670 nm, particularly preferably in the range of between 570 nm and 585 nm.

14. Hob according to any of the preceding claims,
**characterized**
**in that** the illuminant (4) comprises an optical scattering element (6).

15. Hob according to any of the preceding claims,
**characterized**
**in that** one or more elements (2.1, 2.2) are arranged on or in the region of the display side (1.1) and/or the rear side (1.2), said one or more elements being arranged at least regionally in the display region produced by the illuminant (4).

16. Hob according to any of the preceding claims, **characterized**
**in that** a light sensor (10) captures part of the light emitted on the display side (1.1).

17. Hob according to any of the preceding claims,
**characterized**
**in that** the illuminant (4) comprises primary colour luminaires (4.1) by means of which the primary colours of a colour polygon are generatable, such that on the display side (1.1) of the substrate (1) a colour polygon is representable which contains at least partly the white region W1, preferably partly the white region W2, with the CIExyY (1931) coordinates:
| **White regions W1, W2** | | | | | |
|---|---|---|---|---|---|
| | **x** | **y** | | **x** | **y** |
| **W1** | 0.3 | 0.25 | **W2** | 0.3068 | 0.3113 |
| | 0.26 | 0.33 | | 0.3028 | 0.3304 |
| | 0.37 | 0.43 | | 0.3205 | 0.3481 |
| | 0.51 | 0.48 | | 0.3207 | 0.3462 |
| | 0.48 | 0.35 | | 0.3376 | 0.3616 |
| | 0.35 | 0.3 | | 0.3551 | 0.376 |
| | 0.3 | 0.25 | | 0.3548 | 0.3736 |
| | | | | 0.3736 | 0.3874 |
| | | | | 0.4006 | 0.4044 |
| | | | | 0.3996 | 0.4015 |
| | | | | 0.4299 | 0.4165 |
| | | | | 0.4562 | 0.426 |
| | | | | 0.4813 | 0.4319 |
| | | | | 0.4593 | 0.3944 |
| | | | | 0.4147 | 0.3814 |
| | | | | 0.3889 | 0.369 |
| | | | | 0.3898 | 0.3716 |
| | | | | 0.367 | 0.3578 |
| | | | | 0.3512 | 0.3465 |
| | | | | 0.3515 | 0.3487 |
| | | | | 0.3366 | 0.3369 |
| | | | | 0.3222 | 0.3243 |
| | | | | 0.3221 | 0.3261 |
| | | | | 0.3068 | 0.3113 |

18. Hob according to any of the preceding claims,
**characterized**
**in that** the illuminant (4) comprises primary colour luminaires (4.1) by means of which the primary colours of a colour polygon are generatable, such that on the display side (1.1) of the substrate (1) a colour polygon is representable which contains the achromatic point x=1/3, y=1/3 (CIExyY 2°, 1931).

19. Hob according to any of the preceding claims,
**characterized**
**in that** the illuminant (4) comprises, as primary colour luminaires (4.1), white, blue or UV illuminants in combination with narrowband colour filters or in combination with colour luminescence materials.

20. Hob according to any of the preceding claims,
**characterized**
**in that** the illuminant (4) comprises, as primary colour luminaires (4.1), laser diodes or light guide sources.

21. Hob according to any of the preceding claims,
**characterized**
**in that** the illuminant (4) is shielded at least regionally by a light-tight enclosure (11.2).

22. Hob according to any of the preceding claims,
**characterized**
**in that** a plurality of illuminants (4) form a segment display, and
**in that** each illuminant (4) comprises at least two, preferably three, primary colour luminaires (4.1) .

23. Hob according to any of Claims 1 to 22,
**characterized**
**in that** the illuminants (4) form a seven-segment display.

24. Hob according to any of the preceding claims,
**characterized**
**in that** the illuminants (4) form pixels of a colour display.

25. Hob according to any of the preceding claims,
**characterized**
**in that** the illuminants (4) form the light source a backlighting of a monochromatic display (for example of an LCD).

26. Hob according to any of the preceding claims,
**characterized**
**in that** the illuminants (4) form the light source a backlighting of a coloured display (for example of an LCD or a TFT).

## Revendications

1. Table de cuisson, pourvue d'un dispositif d'affichage et d'un substrat (1), le substrat (1) étant constitué au moins partiellement d'une matière partiellement transparente, faisant preuve d'une courbe de transmission à spectre inhomogène, le substrat (1) comportant une face d'affichage (1.1) et une face arrière (1.2), dans la région de la face arrière (1.2) étant placé au moins un élément lumineux (4), et l'élément lumineux (4) comportant au moins deux témoins en couleurs primaires (4.1), **caractérisée**
**en ce que** la luminosité des couleurs primaires d'au moins l'un des témoins en couleurs primaires (4.1) est corrigée,
**en ce que** la transmission maximale du corps en vitrocéramique formant le substrat est < 40% dans le domaine spectral de 400 nm à 700 nm et est en moyenne < 4 % dans le domaine spectral de 450 nm à 600 nm,
et **en ce qu'**au moyen d'un module de réglage (18), la composition spectrale de la lumière émise par l'élément lumineux (4) est pré-réglable et variable,
ou en ce que les témoins en couleurs primaires (4.1) de l'élément lumineux (4) sont formés par des LED à amorçage séquentiel.

2. Table de cuisson selon la revendication 1, **caractérisée en ce que** dans la plage de longueurs d'ondes comprise entre 470 nm et 630 nm, le substrat fait preuve d'une différence de transmission dτ > 50 %.

3. Table de cuisson selon la revendication 2, **caractérisée en ce que** dans la plage de longueurs d'ondes comprise entre 470 nm et 630 nm, le substrat fait preuve d'une différence de transmission dτ > 80 %.

4. Table de cuisson selon la revendication 3, **caractérisée en ce que** dans la plage de longueurs d'ondes comprise entre 470 nm et 630 nm, le substrat fait preuve d'une différence de transmission 95 % > dτ > 80 %.

5. Table de cuisson selon la revendication l'une quelconque des revendications 1 à 4, **caractérisée en ce qu'**à une longueur d'onde de 520 nm, la transmission relative du substrat (1) est de l'ordre compris entre 9 % et 15 % et à une longueur d'onde de 470 nm, de l'ordre compris entre 7% et 13%, par rapport à la transmission à une longueur d'onde de 630 nm.

6. Table de cuisson selon l'une quelconque des revendications précédentes, **caractérisée en ce que** chaque fois pour chacun des domaines spectraux de 420 à 500 nm, de 500 à 620 nm et de 550 à 640 nm, la transmission du corps en vitrocéramique est > 0,2 %.

7. Table de cuisson selon la revendication 6, **caractérisée en ce que** chaque fois pour chacun des domaines spectraux de 420 à 500 nm, de 500 à 620 nm et de 550 à 640 nm, la transmission du corps en vitrocéramique est > 0,4 %.

8. Table de cuisson selon l'une quelconque des revendications précédentes, **caractérisée en ce que** la transmission maximale du corps en vitrocéramique est < 40 % dans le domaine spectral de 400 nm à 750 nm et est < 4 % dans le domaine spectral de 450 nm à 600 nm.

9. Table de cuisson selon la revendication 8, **caractérisée en ce que** la transmission maximale du corps en vitrocéramique est < 25 % dans le domaine spectral de 400 à 750 nm et < 4 % dans le domaine spectral de 450 à 600 nm.

10. Table de cuisson selon l'une quelconque des revendications précédentes, **caractérisée en ce que** l'élément lumineux (4) comprend trois témoins en couleurs primaires (4.1), un premier émettant de la lumière entre des longueurs d'onde dominantes de 580 nm et 750 nm, un deuxième entre 480 nm et 590 nm et un troisième entre 400 nm et 505 nm.

11. Table de cuisson selon la revendication 10, **caractérisée en ce que** l'élément lumineux (4) comprend trois témoins en couleurs primaires (4.1) qui aux longueurs d'ondes dominantes 470 nm, 520 nm et 630 nm, émettent de la lumière avec un écart de la longueur d'onde dominante ±5 nm.

12. Table de cuisson selon l'une quelconque des revendications 1 à 9, **caractérisée en ce que** l'élément lumineux (4) comprend deux témoins en couleurs primaires (4.1), et **en ce que** dans le diagramme CIExyY (2° Observer), la ligne de liaison des plages chromatiques desdits témoins en couleurs primaires (4.1) recoupe le point blanc W1 ou est tangente à celui-ci, notamment recoupe le point blanc W2 ou est tangente à celui-ci, de manière particulièrement préférentielle, recoupe la courbe de Planck.

13. Table de cuisson selon la revendication 12, **caractérisée en ce que** la longueur d'onde de crête de l'un des deux témoins en couleurs primaires (4.1) se situe dans l'ordre compris entre 420 nm et 510 nm, de manière particulièrement préférentielle, dans l'ordre compris entre 468 nm et 483 nm, et/ou
**en ce que** la longueur d'onde de crête de l'un des deux témoins en couleurs primaires (4.1) se situe dans l'ordre compris entre 550 nm et 670 nm, de manière particulièrement préférentielle, dans l'ordre compris entre 570 nm et 585 nm.

14. Table de cuisson selon l'une quelconque des revendications précédentes, **caractérisée en ce que** l'élément lumineux (4) comporte un élément de dispersion (6) optique.

15. Table de cuisson selon l'une quelconque des revendications précédentes, **caractérisée en ce que** sur ou dans la région de la face d'affichage (1.1) et/ou de la face arrière (1.2) sont placés un ou plusieurs éléments (2.1, 2.2) qui sont placés au moins par endroits dans la région d'affichage créée par l'élément lumineux (4).

16. Table de cuisson selon l'une quelconque des revendications précédentes, **caractérisée en ce qu'**un capteur de lumière (10) absorbe une partie de la lumière émise sur la face d'affichage (1.1).

17. Table de cuisson selon l'une quelconque des revendications précédentes, **caractérisée en ce que** l'élément lumineux (4) comporte des éléments témoins en couleurs primaires (4.1) au moyen desquels les couleurs primaires d'un polygone chromatique peuvent être créées, de sorte que sur la face d'affichage (1.1), du substrat (1) puisse être représenté un polygone chromatique, lequel contient au moins partiellement le point blanc W1, de préférence, partiellement le point blanc W2, avec les coordonnées CIExyY (1931):
| **Points blancs W1 W2** | | | | | |
|---|---|---|---|---|---|
| | **x** | **v** | | **x** | **v** |
| **W1** | 0,3 | 0,25 | **W2** | 0,3068 | 0,3113 |
| | 0,26 | 0,33 | | 0,3028 | 0,3304 |
| | 0,37 | 0,43 | | 0,3205 | 0,3481 |
| | 0,51 | 0,48 | | 0,3207 | 0,3462 |
| | 0,48 | 0,35 | | 0,3376 | 0,3616 |
| | 0,35 | 0,3 | | 0,3551 | 0,376 |
| | 0,3 | 0,25 | | 0,3548 | 0,3736 |
| | | | | 0,3736 | 0,3874 |
| | | | | 0,4006 | 0,4044 |
| | | | | 0,3996 | 0,4015 |
| | | | | 0,4299 | 0,4165 |
| | | | | 0,4562 | 0,426 |
| | | | | 0,4813 | 0,4319 |
| | | | | 0,4593 | 0,3944 |
| | | | | 0,4147 | 0,3814 |
| | | | | 0,3889 | 0,369 |
| | | | | 0,3898 | 0,3716 |
| | | | | 0,367 | 0,3578 |
| | | | | 0,3512 | 0,3465 |
| | | | | 0,3515 | 0,3487 |
| | | | | 0,3366 | 0,3369 |
| | | | | 0,3222 | 0,3243 |
| | | | | 0,3221 | 0,3261 |
| | | | | 0,3068 | 0,3113 |

18. Table de cuisson selon l'une quelconque des revendications précédentes, **caractérisée en ce que** l'élément lumineux (4) comporte des éléments témoins en couleurs primaires (4.1), au moyen desquels les couleurs primaires d'un polygone chromatique peuvent être créées, de sorte que sur la face d'affichage (1.1), du substrat (1) puisse être représenté un polygone chromatique lequel contient le point achromatique x=1/3, y=1/3 (CIExyY 2°,1931).

19. Table de cuisson selon l'une quelconque des revendications précédentes, **caractérisée en ce que** l'élément lumineux (4) comprend en tant que témoins en couleurs primaires (4.1) des éléments lumineux blancs, bleus, ou UV, en association avec des filtres de couleur à bande étroite ou en association avec des matériaux luminescents colorés.

20. Table de cuisson selon l'une quelconque des revendications précédentes, **caractérisée en ce que** l'élément lumineux (4) comprend en tant que témoins en couleurs primaires (4.1) des diodes laser ou des sources de guides de lumière.

21. Table de cuisson selon l'une quelconque des revendications précédentes, **caractérisée en ce que** l'élément lumineux (4) est cloisonné au moins par endroits par une enceinte (11.2) opaque à la lumière.

22. Table de cuisson selon l'une quelconque des revendications précédentes, **caractérisée en ce que** plusieurs éléments lumineux (4) forment un affichage segmenté et **en ce que** chaque élément lumineux (4) comporte deux, de préférence trois témoins en couleurs primaires (4.1).

23. Table de cuisson selon l'une quelconque des revendications 1 à 22, **caractérisée en ce que** les éléments lumineux (4) forment un dispositif d'affichage à sept segments.

24. Table de cuisson selon l'une quelconque des revendications précédentes, **caractérisée en ce que** les éléments lumineux (4) forment des pixels d'un afficheur couleur.

25. Table de cuisson selon l'une quelconque des revendications précédentes, **caractérisée en ce que** les éléments lumineux (4) forment la source lumineuse un rétro-éclairage d'un écran monochrome (par exemple d'un LCD)

26. Table de cuisson selon l'une quelconque des revendications précédentes, **caractérisée en ce que** les éléments lumineux (4) forment la source lumineuse un rétro-éclairage d'un écran couleur (par exemple d'un LCD ou d'un TFT) .
